(19) Europäisches Patentamt
European Patent Office
Office européen des brevets

(11) **EP 1 353 444 B1**

(12) **EUROPÄISCHE PATENTSCHRIFT**

(45) Veröffentlichungstag und Bekanntmachung des Hinweises auf die Patenterteilung:
**07.03.2007   Patentblatt 2007/10**

(51) Int Cl.:
***H03M 1/68*** *(2006.01)*

(21) Anmeldenummer: **02007917.4**

(22) Anmeldetag: **09.04.2002**

(54) **Vorrichtung zur Umwandlung eines digitalen Wertes in ein analoges Signal**

Apparatus for converting a digital value into an analog signal

Dispositif pour convertir une valeur numérique en un signal analogique

(84) Benannte Vertragsstaaten:
**DE FR GB IT**

(43) Veröffentlichungstag der Anmeldung:
**15.10.2003   Patentblatt 2003/42**

(73) Patentinhaber: **Infineon Technologies AG**
**81669 München (DE)**

(72) Erfinder:
• **Bachhuber, Marco**
**81476 München (DE)**
• **Schledz, Ralf**
**85406 Zolling (DE)**

(74) Vertreter: **Repkow, Ines et al**
**Jannig & Repkow**
**Patentanwälte**
**Klausenberg 20**
**86199 Augsburg (DE)**

(56) Entgegenhaltungen:
**US-A- 5 977 898**

• **PATENT ABSTRACTS OF JAPAN vol. 017, no. 642 (E-1466), 29. November 1993 (1993-11-29) & JP 05 206858 A (RICOH CO LTD), 13. August 1993 (1993-08-13)**

**Beschreibung**

Die vorliegende Erfindung betrifft eine Vorrichtung gemäß dem Oberbegriff des Patentanspruchs 1, d.h. eine Vorrichtung zur Umwandlung eines a Bits umfassenden digitalen Wertes in ein analoges Signal.

Eine solche Vorrichtung besteht im allgemeinen aus einer Spannungsteilerkette, bei welcher jedem Wert, den der zu wandelnde digitale Wert annehmen kann, ein Abgriff zugeordnet ist, welcher über einen Auswahl-Schalter mit dem Ausgangsanschluß der Vorrichtung verbunden ist.

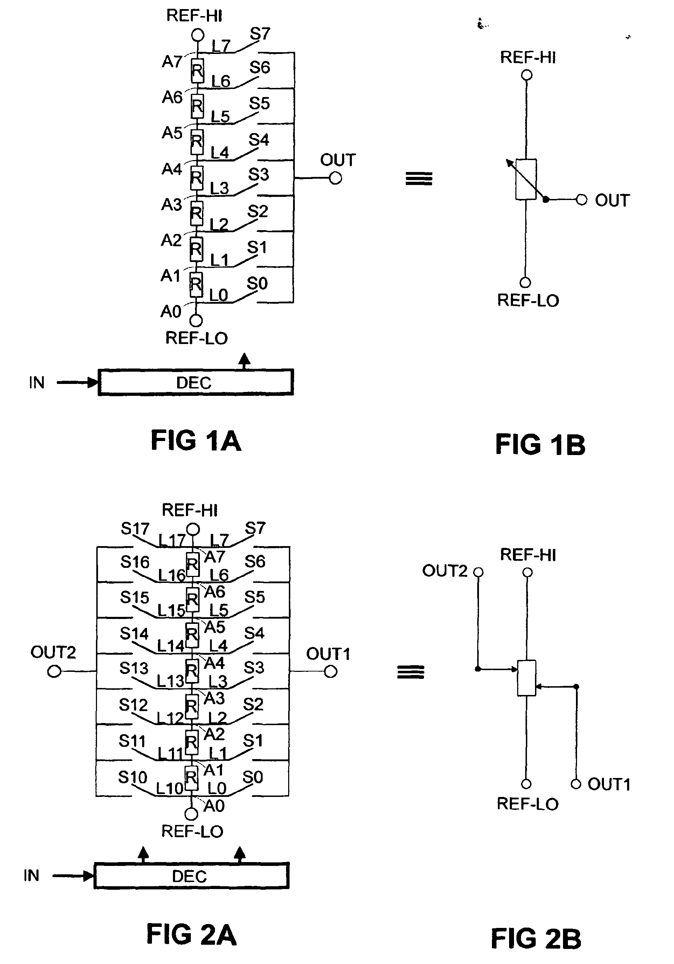

Eine solche Vorrichtung ist beispielhaft in Figur 1A dargestellt.

Die gezeigte Vorrichtung ist zur Umsetzung eines 3 Bits umfassenden digitalen Wertes in ein analoges Signal ausgelegt.

Die Spannungsteilerkette

- umfaßt sieben in Reihe geschaltete Widerstände R,
- wird an den Enden mit Referenzspannungen REF-HI und REF-LO beaufschlagt, und
- weist Abgriffe A0 bis A7 auf.

Von den Abgriffen A0 bis A7 gehen Leitungen L0 bis L7 ab, welche über Auswahl-Schalter S0 bis S7 mit einem Ausgangsanschluß OUT der Vorrichtung verbunden sind.

Die Auswahl-Schalter S0 bis S7 werden durch einen Decoder DEC in Abhängigkeit vom umzuwandelnden digitalen Wert gesteuert; der Decoder DEC weist einen Eingangsanschluß IN auf, über welchen der in ein analoges Signal umzuwandelnde digitale Wert eingegeben wird.

Der Decoder DEC arbeitet beispielsweise so,

- daß er den Auswahl-Schalter S0 schließt und alle anderen Auswahl-Schalter offen hält, wenn der zu wandelnde digitale Wert 000 ist,
- daß er den Auswahl-Schalter S1 schließt und alle anderen Auswahl-Schalter offen hält, wenn der zu wandelnde digitale Wert 001 ist,
- daß er den Auswahl-Schalter S2 schließt und alle anderen Auswahl-Schalter offen hält, wenn der zu wandelnde digitale Wert 010 ist,
- daß er den Auswahl-Schalter S3 schließt und alle anderen Auswahl-Schalter offen hält, wenn der zu wandelnde digitale Wert 011 ist,
- daß er den Auswahl-Schalter S4 schließt und alle anderen Auswahl-Schalter offen hält, wenn der zu wandelnde digitale Wert 100 ist,
- daß er den Auswahl-Schalter S5 schließt und alle anderen Auswahl-Schalter offen hält, wenn der zu wandelnde digitale Wert 101 ist,
- daß er den Auswahl-Schalter S6 schließt und alle anderen Auswahl-Schalter offen hält, wenn der zu wandelnde digitale Wert 110 ist, und
- daß er den Auswahl-Schalter S7 schließt und alle anderen Auswahl-Schalter offen hält, wenn der zu wandelnde digitale Wert 111 ist.

Dadurch liegt am Ausgangsanschluß OUT der Anordnung eine dem digitalen Wert entsprechende analoge Spannung an.

Figur 1B zeigt ein später verwendetes Symbol für die in der Figur 1A gezeigte Vorrichtung.

Eine Vorrichtung der in der Figur 1A gezeigten Art kann auch so ausgebildet werden, daß sie den digitalen Wert in zwei, als differentielle Signale verwendbare analoge Signale umsetzt.

Eine solche Vorrichtung ist in Figur 2A gezeigt.

Die in der Figur 2A gezeigte Vorrichtung enthält wie die in der Figur 1A gezeigte Vorrichtung eine Spannungsteilerkette, welche

- sieben in Reihe geschaltete Widerstände R umfaßt,
- an den Enden mit Referenzspannungen REF-HI und REF-LO beaufschlagt wird, und
- Abgriffe A0 bis A7 aufweist.

Von den Abgriffen A0 bis A7 gehen auch wiederum Leitungen L0 bis L7 ab, welche über Auswahl-Schalter S0 bis S7 mit einem Ausgangsanschluß OUT1 der Vorrichtung verbunden sind.

Von den Abgriffen A0 bis A7 gehen ferner Leitungen L10 bis L17 ab, welche über Auswahl-Schalter S10 bis S17 mit einem zweiten Ausgangsanschluß OUT2 der Vorrichtung verbunden sind.

Die Auswahl-Schalter S0 bis S7 und S10 bis S17 werden durch einen Decoder DEC in Abhängigkeit vom umzuwandelnden digitalen Wert gesteuert; der Decoder DEC weist einen Eingangsanschluß IN auf, über welchen der in ein analoges Signal umzuwandelnde digitale Wert eingegeben wird.

Genauer gesagt wird jeweils einer der Auswahl-Schalter S0 bis S7 und gleichzeitig einer der Auswahl-Schalter S10 bis S17 geschlossen, während alle anderen Auswahl-Schalter jeweils geöffnet sind.

Dadurch gibt die in der Figur 2A gezeigte Vorrichtung jeweils zwei analoge Spannungen aus. Steuert man die Auswahl-Schalter S0 bis S7 und S10 bis S17 so an, daß das dem zu wandelnden digitalen Wert entsprechende analoge Signal durch Subtraktion des aus dem Ausgangssignal OUT2 ausgegebenen Signals von dem aus dem Ausgangsanschluß OUT1 ausgegebenen Signal (oder umgekehrt) gebildet wird, so können dadurch Störungen eliminiert werden.

Der Decoder DEC arbeitet beispielsweise so,

- daß er die Auswahl-Schalter S0 und S10 schließt und alle anderen Auswahl-Schalter offen hält, wenn der zu wandelnde digitale Wert 000 ist,
- daß er die Auswahl-Schalter S2 und S11 schließt und alle anderen Auswahl-Schalter offen hält, wenn der zu wandelnde digitale Wert 001 ist,
- daß er die Auswahl-Schalter S4 und S12 schließt und alle anderen Auswahl-Schalter offen hält, wenn der zu wandelnde digitale Wert 010 ist,
- daß er die Auswahl-Schalter S6 und S13 schließt und alle anderen Auswahl-Schalter offen hält, wenn der zu wandelnde digitale Wert 011 ist,
- daß er die Auswahl-Schalter S7 und S13 schließt und alle anderen Auswahl-Schalter offen hält, wenn der zu wandelnde digitale Wert 100 ist,
- daß er die Auswahl-Schalter S7 und S12 schließt und alle anderen Auswahl-Schalter offen hält, wenn der zu wandelnde digitale Wert 101 ist,
- daß er die Auswahl-Schalter S7 und S11 schließt und alle anderen Auswahl-Schalter offen hält, wenn der zu wandelnde digitale Wert 110 ist, und
- daß er die Auswahl-Schalter S7 und S10 schließt und alle anderen Auswahl-Schalter offen hält, wenn der zu wandelnde digitale Wert 111 ist.

Figur 2B zeigt ein später verwendetes Symbol für die in der Figur 2A gezeigte Vorrichtung.

Wenn eine Vorrichtung gemäß der Figur 1A oder gemäß der Figur 2A Bestandteil einer integrierten Schaltung ist, wird die Spannungsteilerkette im allgemeinen als langgestreckte Widerstandsbahn, d.h. ohne diskrete Widerstands-Bauelemente realisiert. Dabei sind die Widerstandsbahn und die Abgriffe so ausgebildet und angeordnet, daß die Widerstandsbahn zwischen zwei banachbarten Abgriffen jeweils einen elektrischen Widerstand aufweist, der dem elektrischen Widerstand eines der Widerstände R der in den Figuren 1A und 2A gezeigten Anordnungen entspricht.

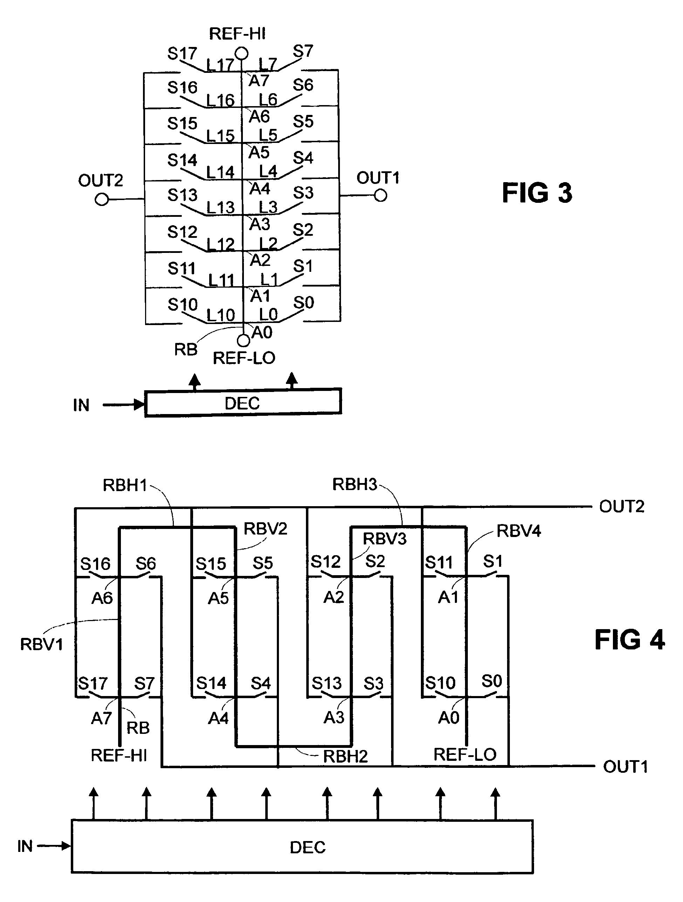

Eine Vorrichtung mit einer so realisierten Spannungsteilerkette ist in Figur 3 gezeigt. Die in der Figur 3 gezeigte Vorrichtung entspricht der in der Figur 2A gezeigten Vorrichtung. Gleiche Bezugszeichen bezeichnen gleiche oder einander entsprechende Komponenten. Der einzige Unterschied zwischen der in der Figur 3 gezeigten Vorrichtung und der in der Figur 2A gezeigten Vorrichtung besteht darin, daß die in der Figur 3 gezeigte Vorrichtung keine diskreten Widerstände R aufweist. Statt dessen ist eine Widerstandsbahn RB vorgesehen, welche zwischen benachbarten Abgriffen jeweils einen elektrischen Widerstand aufweist, der dem elektrischen Widerstand eines der Widerstände R der in den Figuren 1A und 2A gezeigten Anordnungen entspricht.

Durch Weglassen der Leitungen S10 bis S17, der Auswahl-Schalter S10 bis S17, und des zweiten Ausgangsanschlusses OUT2 erhält man eine Vorrichtung, die der in der Figur 1A gezeigten Vorrichtung entspricht.

Der Vollständigkeit halber sei angemerkt, daß die Widerstandsbahn RB durch eine Poly-Schicht des die integrierte Schaltung enthaltenden Halbleiter-Chips gebildet wird. Von den von den Abgriffen A0 bis A7 abgehenden Leitungen L0 bis L7 und L10 bis L17 wird der erste Teil ebenfalls durch eine Poly-Schicht gebildet, und der zweite Teil durch eine oberhalb der Poly-Schicht vorgesehene Metall-Schicht, wobei der Übergang der Leitungen von der Poly-Schicht in die Metall-Schicht, genauer gesagt die hierfür vorgesehene Durchkontaktierung zur Verbindung dieser Schichten weit entfernt von den Abgriffen A0 bis A7 vorgesehen ist, damit die Durchkontaktierung keinen Einfluß auf den durch die Widerstandsbahn fließenden Strom nehmen kann. Ferner sei angemerkt, daß über die Leitungen L0 bis L7 und L10 bis L17 kein oder nur ein sehr geringer Strom fließen darf, weil dies die D/A-Umsetzung beeinflussen würde. Letzteres gilt übrigens auch für alle anderen Vorrichtungen, bei welchen die D/A-Umsetzung unter Verwendung von Spannungsteilerketten erfolgt.

Die Realisierung der Spannungsteilerkette durch eine Widerstandsbahn ist relativ einfach, doch bereitet es unter gewissen Umständen Probleme, einen eine solche Widerstandsbahn enthaltenden D/A-Wandler in eine integrierte Schaltung zu integrieren. Dies ist insbesondere dann der Fall, wenn durch den D/A-Wandler ein eine große Anzahl von Bits umfassender digitaler Wert in ein analoges Signal umgesetzt werden soll. In diesem Fall müssen entlang der Widerstandsbahn sehr viele Abgriffe vorgesehen werden, wodurch die Widerstandsbahn sehr lang wird. Dadurch bekommt der D/A-Wandler eine ungünstige Form (lang und schmal), die es schwierig oder teilweise sogar unmöglich macht, den D/A-Wandler so auf dem die integrierte Schaltung tragenden Halbleiter-Chip zu platzieren, daß die durch die integrierte Schaltung belegte Chipfläche minimal ist.

Zur Vermeidung dieses Problems könnte vorgesehen werden, die Widerstandsbahn mäanderförmig zu falten.

Eine Vorrichtung mit einer mäanderförmig gefalteten Widerstandsbahn ist in Figur 4 veranschaulicht.

Die in der Figur 4 gezeigte Anordnung entspricht weitestgehend der in der Figur 3 gezeigten Anordnung. Unterschiedlich ist nur der Verlauf der Widerstandsbahn RB.

Die in der Figur 4 gezeigte Widerstandsbahn weist vertikal verlaufende Abschnitte RBV1 bis RBV4, sowie horizontal verlaufende Abschnitte RBH1 bis RBH3 auf.

Wie aus der Figur 4 ersichtlich ist, kann durch die Verwendung einer mäanderförmig gefalteten Widerstandsbahn RB das Längen-/Breitenverhältnis der die Widerstandsbahn enthaltenden Vorrichtung wunschgemäß variiert werden, wodurch eine solche Vorrichtung einfacher und effizienter auf einem Halbleiter-Chip anordenbar ist.

Allerdings weist eine mäanderförmig gefaltete Widerstandsbahn RB auch Nachteile auf.

Einer dieser Nachteile besteht darin, daß die Widerstandsbahn RB an den Ecken, d.h. an den Übergängen zwischen den vertikal verlaufenden Abschnitten RBV und den horizontal verlaufenden Abschnitten RBH einen anderen Widerstand aufweist als in den gerade verlaufenden Abschnitten. Da die Größe dieses Widerstandes in der Praxis stark variiert, ist es unvermeidbar daß sich zwischen den Abgriffen, die über einen horizontalen Abschnitt RBH der Widerstandsbahn miteinander verbunden sind, ein anderer Widerstand einstellt als zwischen Abgriffen, die über einen vertikalen Abschnitt RBV der Widerstandsbahn miteinander verbunden sind.

Ein weiterer Nachteil einer mäanderförmig gefalteten Widerstandsbahn RB besteht darin, daß die vertikalen Abschnitte RBV der Widerstandsbahn RB aufgrund der Auswahl-Schalter S0 bis S7 und S10 bis S17, die zwischen diesen vorgesehen werden müssen, einen relativ großen Abstand voneinander aufweisen müssen, wodurch die horizontalen Abschnitte RBH der Widerstandsbahn relativ lang sein müssen. Dies hat zur Folge, daß die Abgriffe, die über die horizontalen Abschnitte RBH der Widerstandsbahn miteinander verbunden sind, über einen relativ langen Teil der Widerstandsbahn miteinander verbunden sind, und dies wiederum erfordert, daß auch die Abgriffe, die über vertikale Abschnitte RBV der Widerstandsbahn miteinander verbunden sind, ebenfalls einen so großen Abstand voneinander aufweisen müssen. Anderenfalls wären die Abgriffe ungleichmäßig über die Widerstandsbahn verteilt, was zu einer nichtlinearen Umsetzung des in ein analoges Signal umzuwandelnden digitalen Wertes führen würde. Die daraus resultierenden großen Abstände zwischen den Abgriffen haben zur Folge, daß eine Vorrichtung mit einer mäanderförmig gefalteten Widerstandsbahn mehr Platz beansprucht als eine Vorrichtung mit einer gerade verlaufenden Widerstandsbahn.

Die genannten Probleme könnten beseitigt werden, indem die horizontalen Abschnitte RBH der Widerstandsbahn RB in einer Metall-Schicht des die Vorrichtung enthaltenden Halbleiter-Chips geführt werden.

Hierbei müßte allerdings der Nachteil in Kauf genommen werden, daß die Widerstandsbahn Kontaktstellen, genauer gesagt Durchkontaktierungen zur Verbindung der Poly-Schicht und der Metall-Schicht aufweist. Diese Kontaktstellen weisen stark streuende Widerstände auf, wodurch die Widerstände der zwischen benachbarten Abgriffen verlaufenden Abschnitte der Widerstandsbahn variieren können, und folglich ebenfalls keine lineare Umsetzung des in ein analoges Signal umzuwandelnden digitalen Wertes gewährleisten können.

Eine weitere Vorrichtung gemäß dem Oberbegriff des Patentanspruchs 1 ist aus der US-A-5 977 898 bekannt. Diesem Stand der Technik sind jedoch keine Anregungen zur Lösung der vorstehend erwähnten Probleme entnehmbar.

Der vorliegenden Erfindung liegt daher die Aufgabe zugrunde, die Vorrichtung gemäß dem Oberbegriff des Patentanspruchs 1 derart weiterzubilden, daß diese einfach und effizient auf einem Halbleiter-Chip unterbringbar ist, und eine vollkommen lineare Umsetzung des in ein analoges Signal umzuwandelnden digitalen Wertes gewährleistet ist.

Diese Aufgabe wird erfindungsgemäß durch den in Patentanspruch 1 beanspruchten D/A-Wandler gelöst.

Die erfindungsgemäße Vorrichtung zeichnet sich dadurch aus, daß sie $2^b$ D/A-Wandler aufweist,

- wobei b eine ganzzahlige Zahl ist, welche größer als 0 ist,
- wobei jeder der D/A-Wandler zur Wandlung eines a-b Bits umfassenden digitalen Wertes ausgelegt ist, und
- wobei der digitale Wert, der - für i=1 ... $2^b$ - dem i-ten D/A-Wandler zur D/A-Wandlung zugeführt wird, den a-b höchstwertigen Bits der Summe des durch die Vorrichtung zu wandelnden digitalen Wertes und einem Wert $x_i$ entspricht, wobei die Werte $x_i$ so ausgewählt sind, daß sie die Bedingungen

$$\sum_{i=1}^{2^b} x_i = \sum_{i=1}^{2^b} (i - 1),$$

und

$$x_i = i - 1$$

erfüllen, und

daß das Ausgangssignal der Vorrichtung der Mittelwert der Ausgangssignale der D/A-Wandler ist.

Dadurch, daß die D/A-Wandler zur D/A-Wandlung von nur a-b Bits umfassenden digitalen Werten ausgelegt sind, muß die Spannungsteilerkette bzw. die diese bildende Widerstandsbahn der D/A-Wandler erheblich weniger Abgriffe aufweisen als es bei einem D/A-Wandler der Fall ist, der zur D/A-Wandlung eines a Bits umfassenden digitalen Wertes ausgelegt ist. Als Folge hiervon kann die Spannungsteilerkette bzw. die diese bildende Widerstandsbahn ebenfalls erheblich kürzer sein. Die beanspruchte Vorrichtung kann dadurch auch ohne mäanderförmige Faltung der Spannungsteilerkette bzw. Widerstandsbahn in eine Form gebracht werden, die sich einfacher und effizienter auf einem Halbleiter-Chip unterbringen läßt. Hinzu kommt, daß sich die Form durch Veränderung der Anordnung der mehreren D/A-Wandler und/oder der sonstigen Vorrichtungs-Komponenten wunschgemäß variieren läßt. Damit kann auch ohne ein mäanderförmiges Falten der Spannungsteilerkette bzw. der diese bil denden Widerstandsbahn, und ohne Inkaufnahme der damit verbundenen Probleme und Nachteile eine einfach aufgebaute und effizient einsetzbare Vorrichtung zur Wandlung eines digitalen Wertes in ein analoges Signal geschaffen werden, die zudem eine vollkommen lineare Umsetzung eines digitalen Wertes in ein analoges Signal gewährleistet.

Vorteilhafte Weiterbildungen der Erfindung sind der Unteransprüchen, der folgenden Beschreibung, und den Figuren entnehmbar.

Die Erfindung wird nachfolgend anhand von Ausführungsbeispielen unter Bezugnahme auf die Figuren näher erläutert. Es zeigen

Figur 1    eine herkömmliche Vorrichtung zur Umwandlung eines digitalen Wertes in ein analoges Signal,

Figur 2    eine weitere herkömmliche Vorrichtung zur Umwandlung eines digitalen Wertes in ein analoges Signal,

Figur 3    eine weitere herkömmliche Vorrichtung zur Umwandlung eines digitalen Wertes in ein analoges Signal,

Figur 4    eine Vorrichtung zur Umwandlung eines digitalen Wertes in ein analoges Signal, welche die Nachteile der Vorrichtung gemäß Figur 3 nicht aufweist,

Figur 5    ein erstes Ausführungsbeispiel der im folgenden beschriebenen Vorrichtung zur Umwandlung eines digitalen Wertes in ein analoges Signal,

Figur 6    eine Steuereinrichtung zur Ansteuerung der in der Vorrichtung gemäß Figur 5 enthaltenen D/A-Wandler,

Figur 7    eine anders realisierte Steuereinrichtung zur Ansteuerung der in der Vorrichtung gemäß Figur 5 enthaltenen D/A-Wandler, und

Figur 8    ein zweites Ausführungsbeispiel der im folgenden beschriebenen Vorrichtung zur Umwandlung eines digitalen Wertes in ein analoges Signal,

Die im folgenden beschriebene Vorrichtung ist Bestandteil einer integrierten Schaltung, beispielsweise eines Mikrocontrollers. Die Vorrichtung kann jedoch auch Bestandteil beliebiger anderer integrierter Schaltungen sein, und auch Bestandteil einer normalen, d.h. nicht integrierten Schaltung sein.

Die im folgenden beschriebene Vorrichtung zur Umwandlung eines digitalen Wertes in ein analoges Signal enthält mehrere D/A-Wandler, von welchen jedoch jeder nur zur Wandlung eines digitalen Wertes ausgelegt ist, der weniger Bits aufweist als der durch die Vorrichtung zu wandelnde digitale Wert.

Genauer gesagt ist es so, daß eine Vorrichtung, durch welche ein a Bits umfassender digitaler Wert in einen analogen Wert umgesetzt werden soll, $2^b$ D/A-Wandler aufweist, wobei jeder der D/A-Wandler zur Wandlung eines digitalen Wertes ausgelegt ist, der b Bits weniger aufweist als der durch die Vorrichtung zu wandelnde digitale Wert, und wobei b eine ganzzahlige Zahl ist, welche größer als 0 ist.

Den mehreren D/A-Wandlern werden gleiche oder verschiedene digitale Werte zugeführt, wobei es von dem durch die Vorrichtung zu wandelnden digitalen Wert abhängt, welchem D/A-Wandler welcher digitale Wert zugeführt wird. Genauer gesagt ist es so, daß der digitale Wert, der - für i=1 ... $2^b$ - dem i-ten D/A-Wandler zur D/A-Wandlung zugeführt wird, den a-b höchstwertigen Bits der Summe des durch die Vorrichtung zu wandelnden digitalen Wertes und einem Wert $x_i$ entspricht, wobei die Werte $x_i$ so ausgewählt sind, daß sie die Bedingungen

$$\sum_{i=1}^{2^b} x_i = \sum_{i=1}^{2^b} (i - 1),$$

und

$$x_i = (i - 1) + n\, 2^b$$

erfüllen, wobei n eine beliebige ganzzahlige Zahl ist

Bei dem im folgenden beschriebenen Beispiel ist $x_i$ jeweils i-1. Allerdings besteht hierauf keine Einschränkung; es können auch andere Werte für $x_i$ verwendet werden, die die vorstehend genannten Bedingungen erfüllen.

Als Ausgangssignal der Vorrichtung wird der Mittelwert der Ausgangssignale der D/A-Wandler verwendet.

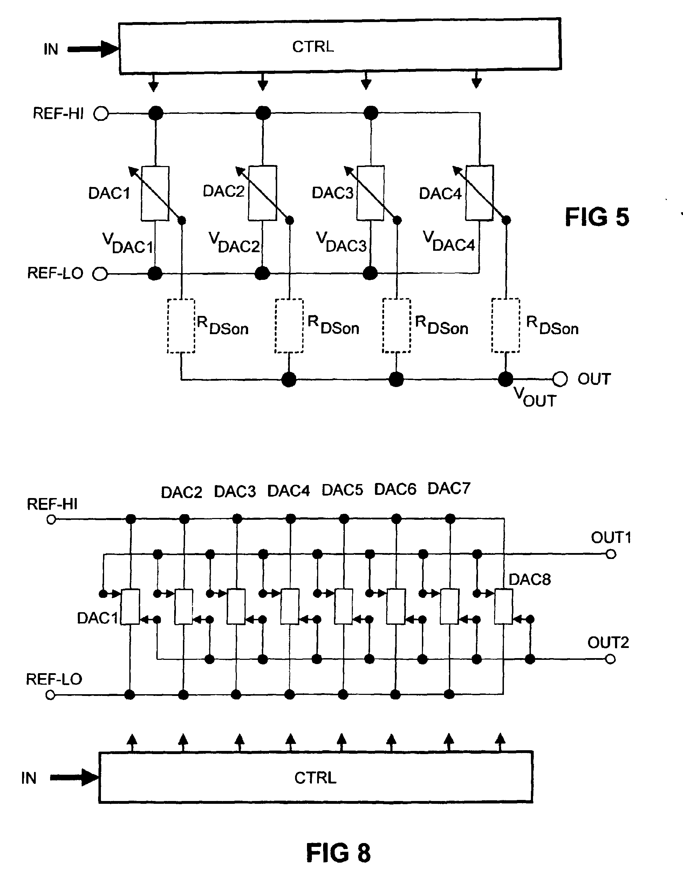

Der Aufbau einer solchen Vorrichtung ist in Figur 5 gezeigt.

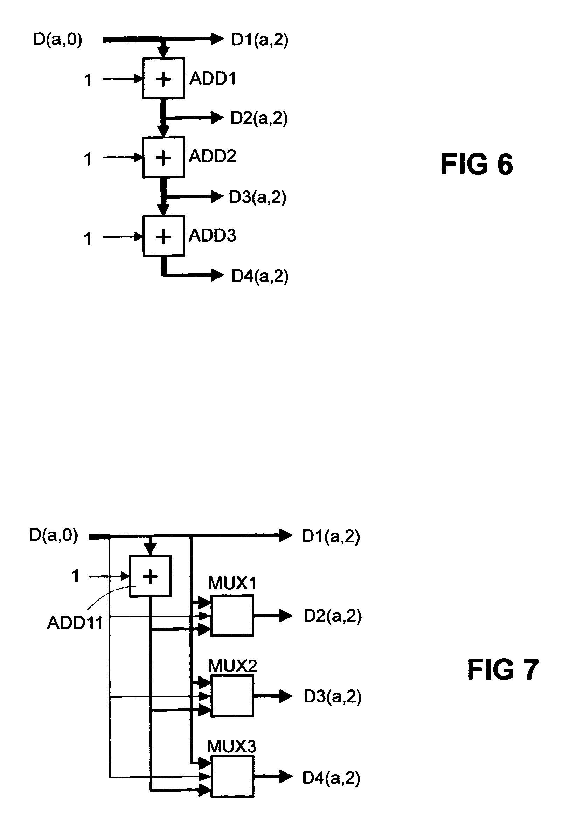

Die in der Figur 5 gezeigte Vorrichtung ist für a=6 und b=2 ausgelegt. Es sei bereits an dieser Stelle darauf hingewiesen, daß eine Vorrichtung nach Art der Figur 5 auch für beliebige andere Werte für a und b konzipiert werden kann. Welche Änderungen hierfür vorzunehmen sind, wird aus der folgenden Beschreibung des Ausbaus und der Funktion der in der Figur 5 gezeigten Vorrichtung klar und bedarf keiner näheren Erläuterung. Entsprechendes gilt übrigens auch für die in den Figuren 6 bis 8 gezeigten Vorrichtungen.

Die in der Figur 5 gezeigte Vorrichtung ist dazu ausgelegt, einen 6 Bits umfassenden digitalen Wert in ein analoges Signal umzusetzen, und weist vier D/A-Wandler DAC1 bis DAC4 auf. Die D/A-Wandler DAC1 bis DAC4 sind jeweils zur Wandlung eines vier Bits umfassenden digitalen Signals in ein analoges Signal ausgelegt, und jeweils wie der in der Figur 1A gezeigte D/A-Wandler aufgebaut, wobei allerdings - wie bei dem in der Figur 3 gezeigten D/A-Wandler - die Spannungsteilerkette durch eine Widerstandsbahn gebildet wird. Die analogen Ausgangssignale $V_{DAC1}$ bis $V_{DAC4}$ der D/A-Wandler DAC1 bis DAC4 werden über Widerstände $R_{DSon}$ auf einen Ausgangsanschluß OUT der Vorrichtung gegeben, wodurch aus dem Ausgangsanschluß OUT eine Spannung $V_{OUT}$ ausgegeben wird, die dem Mittelwert der aus den D/A-Wandlern DAC1 bis DAC4 ausgegebenen Spannungen $V_{DAC1}$ bis $V_{DAC4}$ entspricht. Genauer gesagt gilt:

$$V_{OUT} = 0,25 \, * \, (V_{DAC1} + V_{DAC2} + V_{DAC3} + V_{DAC4})$$

Der Vollständigkeit halber sei angemerkt, daß die Bildung des als Ausgangssignal der Vorrichtung verwendeten Mittelwertes auch auf andere Art und Weise erfolgen könnte.

Die in der Figur 5 gezeigte Vorrichtung enthält darüber hinaus eine Steuereinrichtung CTRL, welchen den D/A-Wandlern die von diesen in ein analoges Signal umzusetzenden digitalen Werte zuführt.

Wie vorstehend bereits erwähnt wurde, ist die in der Figur 5 gezeigte Vorrichtung zur Umsetzung eines 6 Bits umfassenden digitale Wertes in ein analoges Signal ausgelegt. Dieser 6 Bits umfassende digitale Wert wird der Steuereinrichtung CTRL über einen Eingangsanschluß IN derselben als Eingangssignal zugeführt.

Die Steuereinrichtung CTRL

- gibt an den D/A-Wandler DAC1 die höchstwertigen 4 Bits des digitalen 6-Bit-Wertes aus,

- gibt an den D/A-Wandler DAC2 einen digitalen Wert aus, der den höchstwertigen 4 Bits des um 1 erhöhten 6-Bit-Wertes entspricht,

- gibt an den D/A-Wandler DAC3 einen digitalen Wert aus, der den höchstwertigen 4 Bits des um 2 erhöhten 6-Bit-Wertes entspricht, und

- gibt an den D/A-Wandler DAC4 einen digitalen Wert aus, der den höchstwertigen 4 Bits des um 3 erhöhten 6-Bit-Wertes entspricht.

Die D/A-Wandler DAC1 bis DAC4 setzen die ihnen von der Steuereinrichtung CTRL zugeführten digitalen Werte in ein analoges Signal um, und von diesen analogen Signalen wird der vorstehend bereits erwähnte, als Ausgangssignal der Vorrichtung gemäß Figur 5 verwendete Mittelwert gebildet.

Ein Ausführungsbeispiel einer Steuereinrichtung CTRL, die die D/A-Wandler DAC1 bis DAC4 wie erwähnt ansteuert, ist in Figur 6 gezeigt.

Die in der Figur 6 gezeigte Steuereinrichtung weist einen Eingangsanschluß auf, in welchen Daten D(a,0) eingegeben werden, und weist vier Ausgangsanschlüsse auf, über welche Daten D1(a,2), D2(a,2), D3(a,2), und D4(a, 2) ausgegeben werden. Die der Steuereinrichtung zugeführten Daten D(a,0) repräsentieren den durch die Vorrichtung gemäß Figur 5 in ein analoges Signal umzusetzenden digitalen 6-Bit-Wert, und die aus der Steuereinrichtung ausgegebenen Daten D1(a,2), D2(a,2), D3(a,2), und D4(a,2), sind die den D/A-Wandlern DAC1 bis DAC4 zugeführten digitalen 4-Bit-Werte, welche die D/A-Wandler DAC1 bis DAC4 in ein analoges Signal umzusetzen haben. Die Bezeichnung der eingegebenen und ausgegebenen digitalen Daten enthält eine Klammer, in welcher Informationen über die betreffenden Daten enthalten sind: der erste Wert in der Klammer gibt die Anzahl der Bits an, die die betreffenden Daten umfassen, und der zweite Wert in der Klammer gibt die Anzahl der niederwertigsten Bits an, die hiervon abgeschnitten werden bzw. unberücksichtigt bleiben.

Die Steuereinrichtung enthält drei in Reihe geschaltete Addierer ADD1, ADD2, und ADD3, von welchen jeder den ihm zugeführten Wert um 1 erhöht. Dem ersten Addierer ADD1 wird der der Steuereinrichtung zugeführte Wert D (a,0) zugeführt. Der erste Addierer ADD1 erhöht diesen Wert um 1 und gibt das Ergebnis an den zweiten Addierer ADD2 aus. Der zweite Addierer ADD2 erhöht den ihm zugeführten Wert um 1 und gibt das Ergebnis an den dritten Addierer ADD3 aus. Der dritte Addierer ADD3 erhöht den ihm zugeführten Wert um 1 und gibt das Ergebnis aus. Die aus der Steuereinrichtung ausgegebenen Daten D1(a,2) sind die a-2, d.h. die 4 höchstwertigen Bits der der Steuereinrichtung zugeführten Daten D(a,0). Die Daten D2(a,2) sind die a-2, d.h. die 4 höchstwertigen Bits der vom ersten Addierer ADD1 ausgegebenen Daten. Die Daten D3(a,2) sind die a-2, d.h. die 4 höchstwertigen Bits der vom zweiten Addierer ADD2 ausgegebenen Daten. Die Daten D4(a,2) sind die a-2, d.h. die 4 höchstwertigen Bits der vom dritten Addierer ADD3 ausgegebenen Daten.

Durch die Steuereinrichtung werden die D/A-Wandler DAC1 bis DAC4 genau so angesteuert, wie es in der auf die Figur 5 bezugnehmenden Beschreibung in allgemeiner Form erwähnt wurde.

Wenn bei der Erhöhung des digitalen 6-Bit-Wertes der Wert 111111 überschritten wird, also ein Überlauf stattfindet, was beispielsweise der Fall sein kann, wenn der digitale 6-Bit-Wert 111110 beträgt, wird dem D/A-Wandler, dem die 4 höchstwertigen Bits des übergelaufenen Ergebnisses zuzuführen wären, ein Überlauf-Signal zugeführt. Der Empfang eines Überlauf-Signals durch einen D/A-Wandler bewirkt in dem betreffenden D/A-Wandler, daß dieser ein analoges Signal ausgibt, welches an einem zusätzlichen, im folgenden als Überlauf-Abgriff bezeichneten Abgriff der Widerstandsbahn abgegriffen wird. Dieser Überlauf-Abgriff ist zwischen dem Abgriff, der dem digitalen Wert 1111 zugeordnet ist, und dem Referenzspannungs-Anschluß für die Referenzspannung REF-HI vorgesehen, wodurch die D/A-Wandler DAC1 bis DAC4 nicht nur Abgriffe A0 bis A15 aufweisen, sondern auch noch einen weiteren Abgriff A16, wobei dieser weitere Abgriff A16 als Überlauf-Abgriff verwendet wird. Der weitere Abgriff A16 ist wie auch allen anderen Abgriffe über eine zugeordnete eigene Leitung und einen zugeordneten eigenen Auswahl-Schalter mit dem Ausgangsanschluß des jeweiligen D/A-Wandlers verbunden. Wenn ein D/A-Wandler ein Überlauf-Signal zugeführt bekommt, schließt er den dem Überlauf-Abgriff zugeordneten Auswahl-Schalter, und läßt die allen anderen Abgriffen zugeordneten Auswahl-Schalter geöffnet.

Eine weitere Steuereinrichtung, durch welche die D/A-Wandler DAC1 bis DAC4 wie beschrieben angesteuert werden, ist in Figur 7 gezeigt.

Die in der Figur 7 gezeigte Steuereinrichtung weist wie die in der Figur 6 gezeigte Steuereinrichtung einen Eingangsanschluß auf, in welchen Daten D(a,0) eingegeben werden, und weist vier Ausgangsanschlüsse auf, über welche Daten D1(a,2), D2(a,2), D3(a,2), und D4(a,2) ausgegeben werden. Die der Steuereinrichtung zugeführten Daten D(a,0) repräsentieren im betrachteten Beispiel den durch die Vorrichtung gemäß Figur 5 in ein analoges Signal umzusetzenden digitalen 6-Bit-Wert, und die aus der Steuereinrichtung CTRL ausgegebenen Daten D1(a,2), D2(a,2), D3(a, 2), und D4(a,2), sind die den D/A-Wandlern DAC1 bis DAC4 zugeführten digitalen 4-Bit-Werte, welche die D/A-Wandler DAC1 bis DAC4 in ein analoges Signal umzusetzen haben. Die Bezeichnung der eingegebenen und ausgegebenen digitalen Daten enthält eine Klammer, in welcher Informationen über die betreffenden Daten enthalten sind: der erste Wert in der Klammer gibt die Anzahl der Bits an, die die betreffenden Daten umfassen, und der zweite Wert in der Klammer gibt die Anzahl der niederwertigsten Bits an, die abgeschnitten werden.

Die Steuereinrichtung enthält einen Addierer ADD11, welcher den ihm zugeführten Wert um 1 erhöht. Dem Addierer ADD11 werden die vier höchstwertigen Bits des der Steuereinrichtung zugeführten Wertes D(a,0) zugeführt.

Die Steuereinrichtung enthält darüber hinaus drei Multiplexer MUX1 bis MUX3. Jedem der Multiplexer werden

- als Eingangssignale die höchstwertigen 4 Bits der der Steuereinrichtung zugeführten Daten D(a,0) sowie das Ausgangssignal des Addierers ADD11 zugeführt, und

- als Steuersignal die niederwertigsten zwei Bits der der Steuereinrichtung zugeführten Daten D(a,0) zugeführt.

Die Multiplexer MUX1 bis MUX3 sind so konfiguriert,

- daß der Multiplexer MUX1 das Ausgangssignal des Addierers ADD11 durchschaltet, wenn das Steuersignal den Wert 11 aufweist, und ansonsten die höchstwertigen 4 Bits der der Steuereinrichtung zugeführten Daten D(a,0) durchschaltet,

- daß der Multiplexer MUX2 das Ausgangssignal des Addierers ADD11 durchschaltet, wenn das Steuersignal den Wert 10 oder 11 aufweist, und ansonsten die höchstwertigen 4 Bits der der Steuereinrichtung zugeführten Daten D(a,0) durchschaltet, und

- daß der Multiplexer MUX3 das Ausgangssignal des Addierers ADD11 durchschaltet, wenn das Steuersignal den Wert 01, 10, oder 11 aufweist, und ansonsten die höchstwertigen 4 Bits der der Steuereinrichtung zugeführten Daten D(a,0) durchschaltet.

Über den Ausgangsanschluß der Steuereinrichtung, über welchen die Daten D1(a,2) ausgegeben werden, werden immer die höchstwertigen 4 Bits der der Steuereinrichtung zugeführten Daten D(a,0) ausgegeben. Über den Ausgangsanschluß der Steuereinrichtung, über welchen die Daten D2(a,2) ausgegeben werden, werden die vom Multiplexer MUX1 durchgeschalteten Daten ausgegeben. Über den Ausgangsanschluß der Steuereinrichtung, über welchen die Daten D3(a,2) ausgegeben werden, werden die vom Multiplexer MUX2 durchgeschalteten Daten ausgegeben. Über den Ausgangsanschluß der Steuereinrichtung, über welchen die Daten D4(a,2) ausgegeben werden, werden die vom Multiplexer MUX3 durchgeschalteten Daten ausgegeben.

Damit gibt die in der Figur 7 gezeigte Steuereinrichtung exakt die gleichen Daten aus wie die in der Figur 6 gezeigte Steuereinrichtung.

Die in der Figur 7 gezeigte Steuereinrichtung ist jedoch einfacher und kleiner realisierbar als die in der Figur 6 gezeigte Steuereinrichtung, weil sie nur einen Addierer enthält, und weil sich die Multiplexer klein und einfach realisieren lassen.

Wenn bei der in der Figur 7 gezeigten Steuereinrichtung im Addierer ein Überlauf stattfindet, wird den D/A-Wandlern, welchen das Ausgangssignal des Addierers ADD11 zuzuführen ist, ein Überlauf-Signal zugeführt. Dieses Überlauf-Signal bewirkt in den betreffenden D/A-Wandlern die selben Vorgänge wie das aus der Steuereinrichtung gemäß Figur 6 ausgegebene Überlauf-Signal.

Durch die vorstehend bereits erwähnten Widerstände $R_{DSon}$ werden die Ströme begrenzt, die aus den Ausgangsanschlüssen der D/A-Wandler DAC1 bis DAC4 gezogen werden bzw. in diese hineinfließen. Daß hier gewisse Ströme fließen, ist unvermeidbar, weil die aus den Ausgangsanschlüssen der D/A-Wandler DAC1 bis DAC4 ausgegebenen, und am Ausgangsanschluß OUT der Vorrichtung zusammengeführten analogen Signale aufgrund der unterschiedlichen digitalen Werte, die sie zu wandeln haben können, unterschiedliche Spannungen aufweisen können. Solche Ströme können, wenn sie zu groß sind, das Wandlungsergebnis beeinflussen, weil sie über die jeweils geschlossenen Auswahl-Schalter der D/A-Wandler in die Widerstandsbahn derselben eingeprägt werden bzw. aus der Widerstandsbahn herausgezogen werden, was seinerseits wiederum zu einer Veränderung der Spannung führen kann, die sich an dem über den Auswahl-Schalter mit dem Ausgangsanschluß des D/A-Wandlers verbundenen Abgriff einstellt. Die Widerstände $R_{DSon}$ können weggelassen werden, wenn die Widerstände der jeweils geschlossenen Auswahl-Schalter der jeweiligen D/A-Wandler groß genug sind, um die Größe des Ausgleichsstromes ausreichend stark zu begrenzen.

Das analoge Signal, welches über den Ausgangsanschluß OUT der in der Figur 5 gezeigten Vorrichtung ausgegeben wird, weist exakt die selbe Spannung auf wie das analoge Ausgangssignal eines einzigen D/A-Wandlers mit einer entsprechend höheren Auflösung. D.h., durch $2^b$ D/A-Wandler mit a-b Bit Auflösung kann das selbe Ergebnis erzielt werden wie durch einen einzigen D/A-Wandler mit a Bit Auflösung.

Obgleich die in der Figur 5 gezeigte Vorrichtung mehrere, genauer gesagt $2^b$ D/A-Wandler enthält, ist sie nicht größer als ein einziger D/A-Wandler mit a Bit Auflösung. Dies liegt daran, daß ein D/A-Wandler mit a-b Bits Auflösung eine erheblich kürzere Widerstandsbahn benötigt als ein D/A-Wandler mit a Bits Auflösung. Genauer gesagt ist die Widerstandsbahn eines D/A-Wandlers mit a-b Bits Auflösung um den Faktor $2^b$ kürzer als die Widerstandsbahn eines D/A-Wandlers mit a Bits Auflösung (weil die Anzahl der Abgriffe bei einem D/A-Wandlers mit a-b Bits Auflösung um den Faktor $2^b$ kleiner sein kann als die Anzahl der Abgriffe bei einem D/A-Wandlers mit a Bits Auflösung.

Wegen der erheblich geringeren Länge der Widerstandsbahn eines D/A-Wandlers mit a-b Bits Auflösung besteht im allgemeinen keine Notwendigkeit, diese mäanderförmig zu falten, wodurch die eingangs genannten Probleme, die bei mäanderförmig gefalteten Widerstandsbahnen auftreten, nicht auftreten können. D.h. die Widerstandsbahnen weisen über ihre gesamte Länge einen homogenen Widerstand auf.

Weil die beschriebene Vorrichtung mehrere D/A-Wandler enthält, die unabhängig voneinander angeordnet werden können, kann die Vorrichtung so aufgebaut werden, daß sie eine Form aufweist, die sich mit geringem Aufwand so auf einem Halbleiter-Chip platzieren läßt, daß der Halbleiter-Chip die gewünschte Form aufweist, und keine Chipfläche

EP 1 353 444 B1

verschwendet wird, d.h. ungenutzt bleibt.

Die in der Figur 5 gezeigte Vorrichtung kann auch unter Verwendung von differentielle Ausgangssignale liefernden D/A-Wandlern, beispielsweise unter Verwendung von D/A-Wandlern der in der Figur 2A oder der Figur 3 gezeigten Art aufgebaut werden. Eine solche Vorrichtung ist in Figur 8 gezeigt.

Die in der Figur 8 gezeigte Vorrichtung enthält 8 D/A-Wandler DAC1 bis DAC8, von welchen jeder zur Umsetzung eines c Bits umfassenden digitalen Wertes in ein analoges Signal ausgelegt ist, und kann folglich zur Umsetzung eines c+3 Bits umfassenden digitalen Wertes in ein analoges Signal verwendet werden.

Bezugszeichenliste

| | |
|---|---|
| Ax | Abgriff |
| ADDx | Addierer |
| DACx | D/A-Wandler |
| DEC | Decoder |
| IN | Eingangsanschluß |
| Lx | Leitung |
| MUXx | Multiplexer |
| OUT | Ausgangsanschluß |
| OUT1 | Ausgangsanschluß |
| OUT2 | Ausgangsanschluß |
| R | Widerstand |
| RB | Widerstandsbahn |
| $R_{DSon}$ | Widerstand |
| RHVx | horizontal verlaufender Abschnitt von RB |
| RBVx | vertikal verlaufender Abschnitt von RB |
| REF-HI | Referenzspannung |
| REF-LO | Referenzspannung |
| Sx | Auswahl-Schalter |
| $V_{DACx}$ | Ausgangssignal von DACx |
| $V_{OUT}$ | Ausgangsspannung |

**Patentansprüche**

1. Vorrichtung zur Umwandlung eines a Bits umfassenden digitalen Wertes in ein analoges Signal,
   **dadurch gekennzeichnet,**
   **daß** die Vorrichtung $2^b$ D/A-Wandler aufweist,

   - wobei b eine ganzzahlige Zahl ist, welche größer als 0 ist,
   - wobei jeder der D/A-Wandler zur Wandlung eines a-b Bits umfassenden digitalen Wertes ausgelegt ist, und
   - wobei der digitale Wert, der - für i=1 ... $2^b$ - dem i-ten D/A-Wandler zur D/A-Wandlung zugeführt wird, den a-b höchstwertigen Bits der Summe des durch die Vorrichtung zu wandelnden digitalen Wertes und einem Wert $x_i$ entspricht, wobei die Werte $x_i$ so ausgewählt sind, daß sie die Bedingungen

$$\sum_{i=1}^{2^b} x_i = \sum_{i=1}^{2^b} (i-1),$$

   und

$$x_i = i - 1$$

9

erfüllen, und

**daß** das Ausgangssignal der Vorrichtung der Mittelwert der Ausgangssignale der D/A-Wandler ist.

2. Vorrichtung nach Anspruch 1,
   **dadurch gekennzeichnet,**
   **daß** zur Bestimmung der von den D/A-Wandlern zu wandelnden digitalen Werte eine Steuereinrichtung vorgesehen ist, wobei diese Steuereinrichtung

   - $2^b$-1 in Reihe geschaltete Addierer enthält, wobei dem ersten Addierer der von der Vorrichtung zu wandelnde digitale Wert zugeführt wird, und wobei, sofern weitere Addierer vorhanden sind, den weiteren Addierern das Ausgangssignal des jeweils vor ihnen angeordneten Addierers zugeführt wird, und wobei jeder Addierer den ihm zugeführten digitalen Wert um 1 erhöht, und
   - an den ersten D/A-Wandler die höchstwertigen a-b Bits des von der Vorrichtung zu wandelnden digitalen Wertes zur D/A-Wandlung zuführt, und an die weiteren D/A-Wandler die höchstwertigen a-b Bits der Ausgangssignale der Addierer zur D/A-Wandlung zuführt.

3. Vorrichtung nach Anspruch 1,
   **dadurch gekennzeichnet,**
   **daß** zur Bestimmung der von den D/A-Wandlern zu wandelnden digitalen Werte eine Steuereinrichtung vorgesehen ist, wobei diese Steuereinrichtung

   - einen Addierer enthält, welcher die höchstwertigen a-b Bits des von der Vorrichtung zu wandelnden digitalen Wertes um 1 erhöht,
   - $2^b$-1 Multiplexer enthält, welche durch die niederwertigsten b Bits des von der Vorrichtung zu wandelnden digitalen Wertes gesteuert werden, und welche abhängig von den niederwertigsten b Bits des von der Vorrichtung zu wandelnden digitalen Wertes entweder das Ausgangssignal des Addierers oder die höchstwertigen a-b Bits des von der Vorrichtung zu wandelnden digitalen Wertes durchschalten, und
   - an den ersten D/A-Wandler die höchstwertigen a-b Bits des von der Vorrichtung zu wandelnden digitalen Wertes zur D/A-Wandlung zuführt, und an die weiteren D/A-Wandler die Ausgangssignale der Multiplexer zur D/A-Wandlung zuführt.

**Claims**

1. Apparatus for converting a digital value comprising a bits into an analogue signal,
   **characterized**
   **in that** the apparatus has $2^b$ D/A converters,

   - where b is an integer number which is greater than 0,
   - where each of the D/A converters is designed to convert a digital value comprising a-b bits, and
   - where the digital value which is supplied - for i=1 ... $2^b$ - to the ith D/A converter for the purpose of D/A conversion corresponds to the a-b most significant bits in the sum of the digital value which is to be converted by the apparatus and a value $x_i$, where the values $x_i$ are selected such that they satisfy the conditions

$$\sum_{i=1}^{2^b} x_i = \sum_{i=1}^{2^b} (i - 1),$$

and

$$x_i = (i - 1)$$

and

**in that** the output signal from the apparatus is the mean value for the output signals from the D/A converters.

2. Apparatus according to Claim 1,
   **characterized**
   **in that**, to determine the digital values to be converted by the D/A converters, a control device is provided, with this control device

   - containing $2^b$-1 adders connected in series, with the first adder being supplied the digital value to be converted by the apparatus, and, provided that further adders are available, with the further adders being supplied the output signal from the respective adder arranged upstream of them, and with each adder increasing the digital value supplied to it by 1, and
   - supplying to the first D/A converter the most significant a-b bits in the digital value to be converted by the apparatus for the purpose of D/A conversion, and supplying to the further D/A converters the most significant a-b bits in the output signals from the adders for the purpose of D/A conversion.

3. Apparatus according to Claim 1,
   **characterized**
   **in that**, to determine the digital values to be converted by the D/A converters, a control device is provided, with this control device

   - containing an adder which increases the most significant a-b bits in the digital value to be converted by the apparatus by 1,
   - containing $2^b$-1 multiplexers which are controlled by the least significant b bits in the digital value to be converted by the apparatus and which, on the basis of the least significant b bits in the digital value to be converted by the apparatus, switch through either the output signal from the adder or the most significant a-b bits in the digital value to be converted by the apparatus, and
   - supplying to the first D/A converter the most significant a-b bits in the digital value to be converted by the apparatus for the purpose of D/A conversion, and supplying to the further D/A converters the output signals from the multiplexers for the purpose of D/A conversion.

**Revendications**

1. Dispositif de conversion d'une valeur numérique comprenant a bits en un signal analogique, **caractérisé en ce que** le dispositif comporte $2^b$ convertisseurs N/A,

   - b étant un nombre entier supérieur à 0,
   - chacun des convertisseurs N/A étant conçu pour la conversion d'une valeur numérique comportant a-b bits, et
   - la valeur numérique, qui pour i=1 ... $2^b$ est acheminée au i-ème convertisseur N/A pour la conversion N/A, correspondant aux a-b bits de valeurs les plus élevées de la somme de la valeur numérique à convertir par le dispositif et d'une valeur $x_i$, les valeurs $x_i$ étant choisies de telle sorte qu'elles satisfassent aux conditions

$$\sum_{i=1}^{2^b} x_i = \sum_{i=1}^{2^b} (i-1),$$

   et

$$x_i = i - 1$$

   et **en ce que** le signal de sortie du dispositif soit la valeur moyenne des signaux de sortie des convertisseurs N/A.

2. Dispositif selon la revendication 1, **caractérisé en ce qu'**un équipement de commande est prévu pour la détermination des valeurs numériques à convertir par les convertisseurs N/A, cet équipement de commande

- contenant $2^b$-1 additionneurs branchés en série, la valeur numérique à convertir par le dispositif étant acheminée vers le premier additionneur, et le signal de sortie des additionneurs disposés respectivement en amont étant acheminé vers les autres additionneurs dans la mesure où d'autres additionneurs sont disponibles, et chaque additionneur augmentant de 1 la valeur numérique qui lui est acheminée, et

- acheminant au premier convertisseur N/A, les a-b bits de valeurs les plus élevées de la valeur numérique à convertir par le dispositif pour la conversion N/A, et acheminant aux autres convertisseurs N/A, les a-b bits de valeurs les plus élevées des signaux de sortie des additionneurs pour la conversion N/A.

3. Dispositif selon la revendication 1, **caractérisé en ce qu'**un équipement de commande est prévu pour la détermination des valeurs numériques à convertir par les convertisseurs N/A, cet équipement de commande

- contenant un additionneur qui augmente de 1 les a-b bits de valeurs les plus élevées de la valeur numérique à convertir par le dispositif,

- contenant des multiplexeurs $2^b$-1 qui sont commandés par les b bits de valeurs les plus basses de la valeur numérique à convertir par le dispositif, et qui transmettent soit le signal de sortie de l'additionneur, soit les a-b bits de valeurs les plus élevées de la valeur numérique à convertir par le dispositif en fonction des b bits de valeurs les plus basses de la valeur numérique à convertir par le dispositif, et

- acheminant au premier convertisseur N/A, les a-b bits de valeurs les plus élevées de la valeur numérique à convertir par le dispositif pour la conversion N/A, et acheminant aux autres convertisseurs N/A les signaux de sortie des multiplexeurs pour la conversion N/A.

FIG 1A

FIG 1B

FIG 2A

FIG 2B

REF-HI

S17  L17  L7  S7

S16  A7  S6
     L16  L6

S15  A6  S5
     L15  L5

S14  A5  S4
     L14  L4

OUT2  S13  A4  S3  OUT1
      L13  L3

S12  A3  S2
     L12  L2

S11  A2  S1
     L11  L1

S10  A1  S0
     L10  L0  A0

RB  REF-LO

**FIG 3**

IN → DEC

RBH1  RBH3  OUT2

        RBV2        RBV3        RBV4

S16  S6  S15  S5  S12  S2  S11  S1

A6  RBV1  A5  A2  A1

REF-HI  RBH2  REF-LO  OUT1

S17  S7  S14  S4  S13  S3  S10  S0

A7  RB  A4  A3  A0

**FIG 4**

IN → DEC

**FIG 5**

**FIG 8**

D(a,0) → D1(a,2)

1 → + ADD1

→ D2(a,2)

1 → + ADD2

→ D3(a,2)

1 → + ADD3

→ D4(a,2)

**FIG 6**

D(a,0) → D1(a,2)

1 → +

ADD11

MUX1 → D2(a,2)

MUX2 → D3(a,2)

MUX3 → D4(a,2)

**FIG 7**